# FASCICULE DE BREVET EUROPEEN

(11) **EP 0 754 795 B1**
(45) Date de publication et mention de la délivrance du brevet: **04.08.1999**
(21) Numéro de dépôt: 96401437.7
(22) Date de dépôt: 28.06.1996
(51) Int. Cl.: D04H 3/04, D04H 18/00

(54) **Procédé et système pour la réalisation d'une armature pour une pièce de matière composite**
Verfahren und System zur Herstellung einer Armierung für ein Verbundmaterialteil
Process and system for making an armature for a part made of composite material

(30) Priorité: 17.07.1995 FR 9508595
(43) Date de publication de la demande: 22.01.1997
(73) Titulaire: AEROSPATIALE SOCIETE NATIONALE INDUSTRIELLE, 75016 Paris (FR)
(72) Inventeur: Cahuzac, Georges, 33110 Le Bouscat (FR)
(74) Mandataire: Bonnetat, Christian

(56) Documents cités:
- EP-A- 0 284 497
- GB-A- 2 110 590
- GB-A- 2 249 050
- US-A- 5 117 348
- US-A- 5 239 457

## Description

La présente invention concerne un procédé et un système pour la réalisation d'une armature pour une pièce de matière composite. Ladite armature comprend des nappes superposées de fil (en carbone, verre, bore, notamment) et est ultérieurement noyée dans une matrice durcie pour former ladite pièce.

Plus particulièrement, quoique non exclusivement, de telles pièces de matière composite sont utilisées dans les domaines aéronautique et spatial en vertu de leurs excellentes propriétés de résistance aux contraintes mécaniques et/ou thermiques.

On connaît de nombreux procédés pour obtenir de telles pièces de matière composite, et en particulier leur armature. De façon générale, on commence par réaliser l'armature à partir de fibres (fils) distribuées suivant au moins deux directions, constituant des nappes superposées de fil, qui peuvent être ensuite liées entre elles par piquage d'un fil traversant transversalement lesdites nappes. Après quoi, on introduit la matière de la matrice dans l'armature, et on durcit ladite matière pour former ladite matrice et, ainsi, ladite pièce composite.

La dépose des nappes de fils peut être effectuée de différentes façons. Ainsi, dans un cas, on implante à demeure, dans un support, des "picots" (brins de fils rigides), autour desquels sont déposées des nappes de fils dans deux directions différentes, lesdits picots solidarisant par ailleurs lesdites nappes entre elles (brevet FR-A-2 408 676).

Dans un autre cas, illustré notamment par le brevet EP-B-0 284 497 de la demanderesse, on utilise une tête de dépose de fil permettant de tendre chaque tronçon de fil entre des points de fixation en position de ses extrémités, matérialisés par des épingles implantées provisoirement dans un support, réalisé dans une matière pouvant être pénétrée par lesdites épingles, comme une mousse de matière synthétique. Après formation des nappes superposées de fil et solidarisation desdites nappes entre elles par piquage d'un fil transversal, les épingles sont retirées du support.

Par ailleurs, la demande de brevet français n° 94 04581 de la demanderesse décrit un procédé du type décrit dans le paragraphe précédent, dans lequel on évite l'utilisation d'épingles de guidage et d'une tête de dépose particulière en déposant des tronçons de fil rectilignes par l'intermédiaire d'une aiguille, par rapport à laquelle peut coulisser le fil continu dont fait partie chacun desdits tronçons, en tendant le tronçon de fil rectiligne au-dessus d'un support, et en fixant lesdits tronçons de fil rectilignes par piquage sans nouage des extrémités de chacun desdits tronçons dans ledit support, à l'aide de ladite aiguille.

L'ensemble de ces procédés, notamment le dernier décrit, permet de réaliser sans problèmes particuliers, sinon ceux évoqués dans la demande de brevet français n° 94 04581 concernant les deux premiers procédés décrits, des armatures et donc des pièces de formes simples, par exemple des panneaux plans, ou présentent une certaine courbure, de forme générale rectangulaire, ou des pièces cylindriques. Cependant, pour une application spécifique, il est bien évident que de telles "ébauches" doivent être par la suite découpées et usinées pour obtenir la forme "complexe" souhaitée. Un tel usinage ultérieur prend bien entendu du temps et représente un coût supplémentaire. Il serait donc souhaitable de disposer d'un procédé permettant, de façon simple, la réalisation "directe" d'armatures de formes "complexes". C'est l'objet de la présente invention.

A cet effet, le procédé pour la réalisation d'une armature pour une pièce de matière composite, formée de ladite armature noyée dans une matrice durcie, ladite armature comprenant des nappes superposées de fil, procédé selon lequel :
(a) on réalise au moins certaines desdites nappes en déposant des tronçons de fil rectilignes faisant partie d'un fil continu sur un support, en tendant chaque tronçon de fil entre deux points de fixation en position des extrémités dudit tronçon, la nappe étant ainsi constituée de tronçons de fil s'étendant au moins sensiblement parallèlement les uns par rapport aux autres, et les tronçons de fil de ladite nappe s'étendant suivant une direction, soit parallèle, soit croisée par rapport à la direction des tronçons de fils d'une autre nappe quelconque de l'armature ; et
(b) on solidarise entre elles l'ensemble des nappes superposées, notamment par piquage sans nouage d'un fil continu traversant lesdites nappes,
est remarquable, selon l'invention, en ce que, préalablement à l'étape (a), on crée le modèle mathématique de l'armature à réaliser et on mémorise celui-ci, et, pour chaque nappe à réaliser de l'armature, on définit, à l'aide des données mémorisées du modèle mathématique de l'armature, le contour de ladite nappe ainsi que le positionnement de celui-ci par rapport à la nappe précédente, déjà réalisée, et, ensuite, on commande le processus de l'étape (a).

Ainsi, le procédé selon l'invention permet de réaliser, de manière simple et industrielle, des armatures pour des pièces composites complexes (c'est-à-dire qui peuvent être très épaisses, d'épaisseur variable et de profil évolutif), à partir de leur modèle mathématique, lesdites pièces présentant une armature textile comportant des nappes successives, orientées à volonté, et dont la forme dépend, à chaque fois, du modèle mathématique correspondant au niveau (nappe) concerné. En d'autres termes, après avoir créé le modèle mathématique de la pièce à réaliser, on le "découpe en tranches", l'épaisseur d'une tranche correspondant à celle d'une nappe de fil.

Avantageusement, pour chaque nappe de fil à déposer, on génère l'intersection de la surface d'enveloppe de l'armature avec un plan de coupe situé à la hauteur correspondant à ladite nappe, en obtenant ainsi une courbe fermée, puis on définit les points d'intersection de cette courbe avec un réseau, de pas égal au pas des fils à déposer, de plans orthogonaux au plan défini par ladite courbe fermée et présentant une direction correspondant à celle choisie comme orientation des fils de ladite nappe.

De préférence, dans l'étape (a) :
- on dépose lesdits tronçons de fil rectilignes par l'intermédiaire d'une aiguille, par rapport à laquelle peut coulisser le fil continu dont fait partie chacun desdits tronçons, ladite aiguille étant susceptible de se déplacer relativement audit support, en tendant le tronçon de fil rectiligne au-dessus de ce dernier, sur une course égale à la longueur dudit tronçon de fil rectiligne ; et
- on fixe lesdits tronçons de fil rectilignes par piquage sans nouage d'au moins une des extrémités de chacun desdits tronçons de fil dans ledit support, à l'aide de ladite aiguille.

Par ailleurs, le système pour la mise en oeuvre du procédé qui vient d'être décrit, du type comportant un outil de dépose et/ou de piquage de fil, lié à des moyens de pilotage dudit outil, destinés à déplacer ce dernier suivant trois directions X, Y, Z transversales entre elles, est remarquable, selon l'invention, en ce qu'il comprend des moyens de mémorisation et de traitement de données, dans lesquels peut être créé et mémorisé le modèle mathématique de l'armature à réaliser et qui sont aptes à commander lesdits moyens de pilotage dudit outil.

Lesdits moyens de mémorisation et de traitement, en d'autres termes un ordinateur ou un micro-ordinateur, permettent de mettre en oeuvre le procédé ci-dessus, selon un principe de Conception Assistée par Ordinateur. Chaque nappe de l'armature est transformée en un fichier de points X, Y, Z, y compris l'orientation des fils de la nappe, ledit fichier servant à commander les moyens de pilotage de l'outil de dépose et/ou de piquage de fil, qui ira implanter le fil aux points définis par ce fichier.

Ainsi, à partir d'un modèle de l'armature créé par CAO, le procédé et le système de l'invention permettent de déterminer chaque nappe de fil dans son contour et dans sa position précise par rapport à la nappe immédiatement sous-jacente (un peu comme pour une carte géographique avec ses différentes courbes de niveau). Cela permet donc de décomposer une armature (pièce) par CAO pour limiter ses contours à une tranche, les coupes successives correspondant à une couche de dépose de fil. Cette technique permet de fabriquer une pièce en matériau composite tissé, partant du modèle mathématique pour obtenir le modèle physique. Bien entendu, chaque nappe, correspondant à un niveau de coupe, peut être réalisée par un tissage particulier. Les orientations des fils dans le corps de la pièce peuvent être choisies pour répondre aux caractéristiques demandées.

De préférence, ledit outil de dépose et/ou de piquage de fil est monté sur un support rotatif à l'extrémité inférieure duquel est agencée une aiguille.

Par ailleurs, lesdits moyens de pilotage peuvent comprendre un bâti pourvu d'un piétement et de montants présentant, chacun, une glissière pour le montage d'une barre transversale sur laquelle est monté un chariot, déplaçable suivant une première direction X, muni d'un premier bras s'étendant suivant une deuxième direction Y orthogonale à la direction X et portant un second bras pouvant coulisser transversalement par rapport au plan défini par ladite barre et ledit premier bras suivant une troisième direction Z, et des moyens moteurs pour entraîner ledit chariot et lesdits premier et second bras.

Les figures du dessin annexé feront bien comprendre comment l'invention peut être réalisée.

La figure 1 illustre en perspective, de façon très schématique, le système selon l'invention.

La figure 2 montre, en perspective, un exemple de réalisation du système selon l'invention.

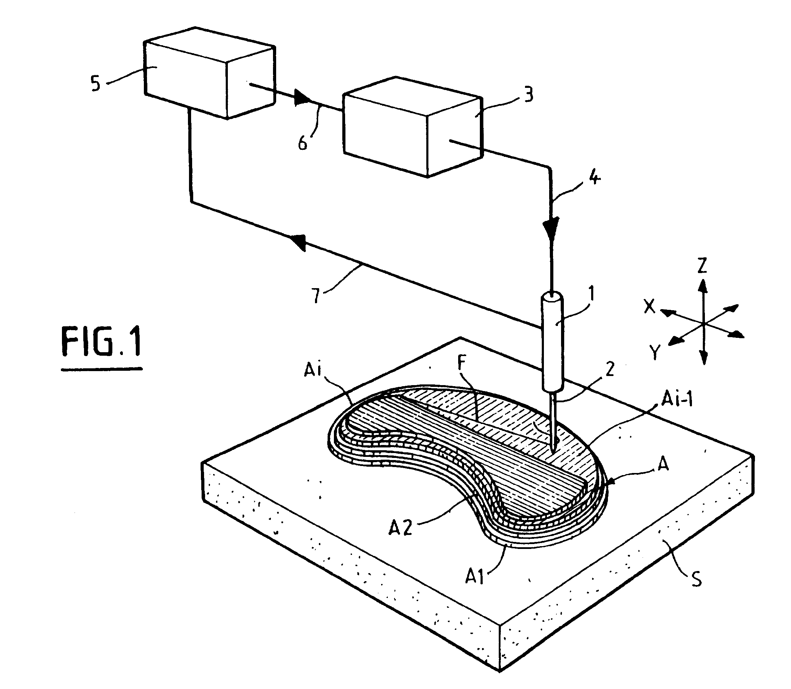

On voit, sur la figure 1, que le système selon l'invention comporte un outil 1 de dépose et/ou de piquage de fil F, pourvu pour ce faire, dans cet exemple, d'une aiguille 2, ledit outil 1 étant lié à des moyens de pilotage 3 de celui-ci (liaison 4), destinés à le déplacer suivant trois directions X, Y, Z transversales entre elles, sous la commande (dont les modalités sont explicitées par la suite) de moyens de mémorisation et de traitement de données 5 (ordinateur ou micro-ordinateur), reliés aux moyens de pilotage 3 et à l'outil 1 par les liaisons respectives 6 et 7.

Par ailleurs, sur la figure 1, on a représenté, schématiquement et, pour ainsi dire, symboliquement, une armature A, disposée sur un support S, en train d'être réalisée. Il est bien entendu que la forme, représentée sur cette figure, ne correspond à aucune pièce particulière, mais a été choisie, de façon arbitraire, uniquement dans un but d'illustration de l'invention. De plus, les différentes couches ou nappes de fil A1, ..., Ai la constituant ne représentent également qu'une illustration symbolique permettant de bien les visualiser. En réalité, de telles nappes constituées d'une (ou éventuellement plusieurs) couche(s) de fil présentant une orientation définie, du fait de l'épaisseur des fils utilisés, seraient pratiquement confondues. En outre, on a représenté une nappe (la plus supérieure) dont les fils s'étendent suivant la direction X et une nappe, immédiatement sous-jacente, dont les fils s'étendent dans la direction Y. Il est bien entendu que d'autres orientations sont également possibles, par rapport à ces deux directions. Ainsi, si la direction X est à 0° et la direction Y à 90°, la dépose des tronçons de fil peut s'effectuer notamment à 45° et 135°, ou suivant un angle quelconque choisi.

Comme déjà indiqué, pour la réalisation d'une armature A pour une pièce de matière composite, formée de ladite armature noyée dans une matrice durcie, ladite armature comprenant des nappes superposées de fil :
(a) on réalise lesdites nappes A1, ..., Ai en déposant des tronçons de fil rectilignes faisant partie d'un fil continu F sur un support S, en tendant chaque tronçon de fil entre deux points de fixation en position des extrémités dudit tronçon, la nappe étant ainsi constituée de tronçons de fil s'étendant au moins sensiblement parallèlement les uns par rapport aux autres, et les tronçons de fil de ladite nappe s'étendant suivant une direction, soit parallèle, soit croisée par rapport à la direction des tronçons de fils d'une autre nappe quelconque de l'armature (comme illustré sur la figure 1) ; et
(b) on solidarise entre elles l'ensemble des nappes superposées, notamment par piquage sans nouage d'un fil continu traversant lesdites nappes.

Pour la dépose du fil, il est avantageux d'utiliser la méthode décrite en détail dans la demande de brevet français n° 94 04581, dans laquelle, en résumé :
- on dépose lesdits tronçons de fil rectilignes par l'intermédiaire d'une aiguille 2, par rapport à laquelle peut coulisser le fil continu F dont fait partie chacun desdits tronçons, ladite aiguille étant susceptible de se déplacer relativement audit support S, en tendant le tronçon de fil rectiligne au-dessus de ce dernier, sur une course égale à la longueur dudit tronçon de fil rectiligne ; et
- on fixe lesdits tronçons de fil rectilignes par piquage sans nouage d'au moins une des extrémités de chacun desdits tronçons de fil dans ledit support S, à l'aide de ladite aiguille 2. Pour ce faire, le support S doit, bien entendu, présenter, d'une part, une souplesse suffisante pour permettre le piquage et, d'autre part, une rigidité ou compacité suffisante pour éviter le retrait du fil.

Plus particulièrement, préalablement à l'étape (a), on crée le modèle mathématique de l'armature à réaliser et on mémorise celui-ci dans l'ordinateur 5, et, pour chaque nappe Ai à réaliser de l'armature A, on définit, à l'aide des données mémorisées du modèle mathématique de l'armature A, le contour de ladite nappe Ai ainsi que le positionnement de celui-ci par rapport à la nappe précédente Ai-1, déjà réalisée, et, ensuite, on commande le processus de l'étape (a) ci-dessus, mis en oeuvre par l'outil de dépose et/ou de piquage de fil 1, à l'aide des moyens de pilotage 3, sous la commande de l'ordinateur 5.

La forme de la pièce (ou de l'armature) peut être définie par tout logiciel adapté. Dans le cas où la pièce finie présente, par exemple, un gauchissement ou vrillage, on peut prendre en compte sa forme plane afin de faciliter la réalisation de l'armature. La forme définitive sera aisément obtenue dans le moule d'injection de la matrice.

Dans le logiciel, pour chaque niveau (couche ou nappe de fil à déposer), on génère l'intersection de la surface d'enveloppe de l'armature avec un plan de coupe situé à la hauteur correspondante. On obtient ainsi une courbe fermée, puis on définit les points d'intersection de cette courbe avec un réseau, de pas égal au pas des fils à déposer, de plans orthogonaux au plan défini par ladite courbe fermée et présentant une direction correspondant à celle choisie comme orientation des fils de la nappe correspondante. Les coordonnées de ces points d'intersection sont sorties sous forme d'un fichier par niveau de coupe. L'ensemble des fichiers, correspondant à l'ensemble des niveaux de coupe, servent de données pour la dépose des fils, commandée par les moyens de pilotage 3 de l'outil 1.

Comme décrit en détail dans la demande de brevet français n° 94 04581 (dans le cas bien sûr où on utilise un procédé par piquage conforme à celui décrit dans ce document), un cycle standard de dépose comprend, pour chaque extrémité d'un tronçon de fil rectiligne, les mouvements suivants de l'outil de dépose de fil 1 :
- déplacement vers le point visé,
- descente verticale,
- descente de piquage dans le support, parallèlement à l'aiguille 2,
- recul de la même course,
- remontée avec rotation de 180° pour repositionner correctement la sortie du fil F relativement au déplacement ultérieur, et
- déplacement vers l'autre extrémité du tronçon de fil.

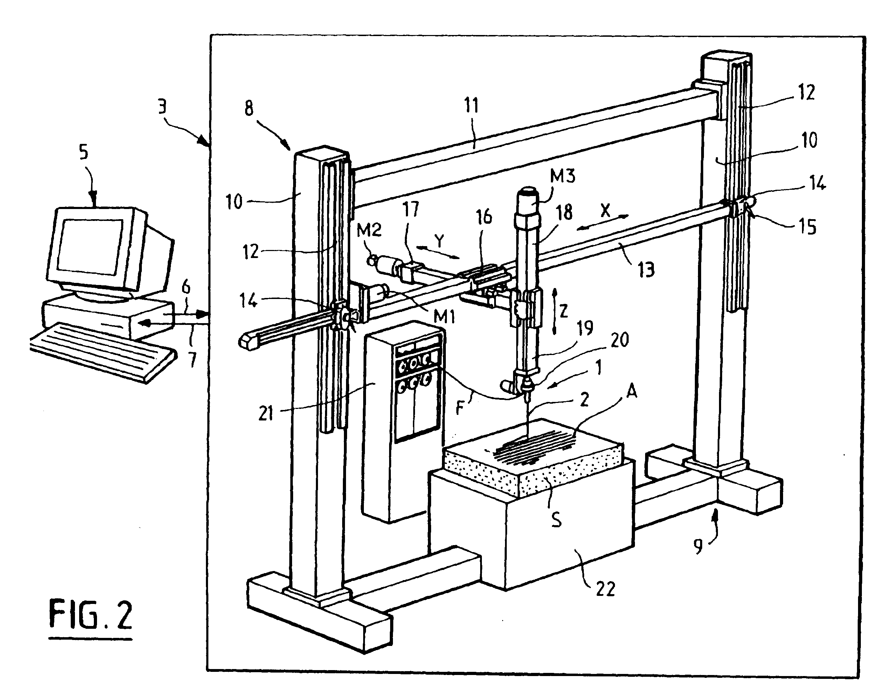

Plus précisément, on voit sur la figure 2 un exemple concret de réalisation (bien entendu non limitatif) d'un système selon l'invention. Les moyens de mémorisation et de traitement de données, constitués d'un ordinateur ou micro-ordinateur 5, sont reliés aux moyens de pilotage 3 de l'outil de dépose et/ou de piquage de fil 1 (liaison 6), lesdits moyens de pilotage 3 comportant un bâti 8 pourvu d'un piétement 9 et de montants verticaux 10, réunis à leur partie supérieure par une traverse horizontale 11. Par ailleurs, chaque montant vertical 10 comporte une glissière 12, et une barre transversale 13 est fixée, au voisinage de ses extrémités, dans des coulisseaux 14 montés dans des glissières 12, dans lesquelles ils peuvent être immobilisés par des vis 15. Grâce à cet agencement, la barre 13 peut être réglée en hauteur sur les montants 10.

Sur la barre 13, il est monté un chariot 16 sur lequel est prévu un bras horizontal 17 coulissant transversalement et de façon réglable par rapport à la barre 13. A l'une de ses extrémités, le bras horizontal 17 porte un bras vertical 18 également coulissant de façon réglable. A son extrémité inférieure 19, le bras vertical 18 présente des moyens de fixation, notamment un support rotatif 20, adaptés pour recevoir l'outil de dépose et/ou de piquage 1 du fil F issu d'une réserve de bobines de fil 21. Un socle 22 est de plus prévu pour recevoir le support S de l'armature A.

On comprend que, grâce à l'agencement de la barre 13 et des bras 17 et 18, l'extrémité 19 peut être réglée dans toute position souhaitée par rapport au support S, suivant trois directions transversales X, Y, Z, notamment orthogonales, au moyen de moteurs Ml, M2 et M3 qui sont représentés, à titre d'exemple, montés sur la barre 13 et aux extrémités des bras 17 et 18 et entraînent ceux-ci suivant ces trois directions par l'intermédiaire de moyens connus appropriés à pignon et crémaillère, vis sans fin ou autres.

Les armatures, ou ébauches, obtenues sont ensuite placées dans un moule dans lequel une résine est injectée et polymérisée pour obtenir la pièce de matière composite. La polymérisation de la résine peut être provoquée par une élévation de température, un faisceau d'électrons, ou tout autre phénomène approprié. On pourrait également utiliser un métal liquide pour imprégner l'armature de façon à obtenir un matériau composite à matrice métallique. On peut aussi réaliser une armature à l'aide de fils enduits de poudre thermoplastique ou comportant des fils thermoplastiques. Dans ce cas, un chauffage puis une compression de cette armature dans un moule fournissent une pièce à matrice thermoplastique.

On peut également envisager que les couches soient déposées sur une nappe de tissu ou de non-tissé. Le ruban passe par une série de postes où il reçoit, à chaque fois, une nappe. Finalement, il est amené sous la presse d'imprégnation où il est imprégné de la matrice et atteint sa forme définitive. Grâce à cela, on peut réaliser des pièces en série.

Par ailleurs, on notera que, pour réaliser une pièce dont la forme est telle qu'elle présente un profil particulier sur les deux faces, il est avantageux et commode de partir d'un tissu central d'épaisseur constante, puis de déposer les nappes sur une face du tissu et ensuite de le retourner pour déposer les nappes sur l'autre face. Dans ce cas, le tissu de support central reste emprisonné entre les deux séries de nappes déposées.

## Revendications

1. Procédé pour la réalisation d'une armature pour une pièce de matière composite, formée de ladite armature noyée dans une matrice durcie, ladite armature comprenant des nappes superposées de fil, procédé selon lequel :
(a) on réalise au moins certaines desdites nappes en déposant des tronçons de fil rectilignes faisant partie d'un fil continu sur un support, en tendant chaque tronçon de fil entre deux points de fixation en position des extrémités dudit tronçon, la nappe étant ainsi constituée de tronçons de fil s'étendant au moins sensiblement parallèlement les uns par rapport aux autres, et les tronçons de fil de ladite nappe s'étendant suivant une direction, soit parallèle, soit croisée par rapport à la direction des tronçons de fils d'une autre nappe quelconque de l'armature ; et
(b) on solidarise entre elles l'ensemble des nappes superposées, notamment par piquage sans nouage d'un fil continu traversant lesdites nappes,
caractérisé en ce que, préalablement à l'étape (a), on crée le modèle mathématique de l'armature à réaliser et on mémorise celui-ci, et, pour chaque nappe à réaliser de l'armature, on définit, à l'aide des données mémorisées du modèle mathématique de l'armature, le contour de ladite nappe ainsi que le positionnement de celui-ci par rapport à 5 la nappe précédente, déjà réalisée, et, ensuite, on commande le processus de l'étape (a).

2. Procédé selon la revendication 1,
caractérisé en ce que, pour chaque nappe de fil à déposer, on génère l'intersection de la surface d'enveloppe de 30 l'armature avec un plan de coupe situé à la hauteur correspondant à ladite nappe, en obtenant ainsi une courbe fermée, puis on définit les points d'intersection de cette courbe avec un réseau, de pas égal au pas des fils à déposer, de plans orthogonaux au plan défini par ladite courbe fermée et présentant une direction correspondant à celle choisie comme orientation des fils de ladite nappe.

3. Procédé selon la revendication 1 ou la revendication 2,
caractérisé en ce que, dans l'étape (a) :
- on dépose lesdits tronçons de fil rectilignes par l'intermédiaire d'une aiguille, par rapport à laquelle peut coulisser le fil continu dont fait partie chacun desdits tronçons, ladite aiguille étant susceptible de se déplacer relativement audit support, en tendant le tronçon de fil rectiligne au-dessus de ce dernier, sur une course égale à la longueur dudit tronçon de fil rectiligne ; et
- on fixe lesdits tronçons de fil rectilignes par piquage sans nouage d'au moins une des extrémités de chacun desdits tronçons de fil dans ledit support, à l'aide de ladite aiguille.

4. Système pour la mise en oeuvre du procédé selon l'une quelconque des revendications 1 à 3, du type comportant un outil (1) de dépose et/ou de piquage de fil (F), lié à des moyens de pilotage (3) dudit outil, destinés à déplacer ce dernier suivant trois directions X, Y, Z transversales entre elles,
caractérisé en ce qu'il comprend des moyens de mémorisation et de traitement de données (5), dans lesquels peut être créé et mémorisé le modèle mathématique de l'armature (A) à réaliser et qui sont aptes à commander lesdits moyens de pilotage (3) dudit outil (1).

5. Système selon la revendication 4,
caractérisé en ce que ledit outil (1) de dépose et/ou de piquage de fil (F) est monté sur un support rotatif (20) à l'extrémité inférieure duquel est agencée une aiguille (2).

6. Système selon la revendication 4 ou la revendication 5,
caractérisé en ce que lesdits moyens de pilotage (3) comprennent un bâti (8) pourvu d'un piétement (9) et de montants (10) présentant, chacun, une glissière (12) pour le montage d'une barre transversale (13) sur laquelle est monté un chariot (16), déplaçable suivant une première direction X, muni d'un premier bras (17) s'étendant suivant une deuxième direction Y orthogonale à la direction X et portant un second bras (18) pouvant coulisser transversalement par rapport au plan défini par ladite barre (13) et ledit premier bras (17) suivant une troisième direction Z, et des moyens moteurs (Ml, M2, M3) pour entraîner ledit chariot (16) et lesdits premier (17) et second (18) bras.

7. Armature pour pièce de matière composite, formée de ladite armature noyée dans une matrice durcie,
caractérisée en ce qu'elle est réalisée conformément au procédé selon l'une quelconque des revendications 1 à 3.

8. Pièce de matière composite,
caractérisée en ce qu'elle est formée par l'armature de la revendication 7, noyée dans une résine durcie.

## Patentansprüche

1. Verfahren zur Herstellung einer Armierung für ein Verbundmaterialteil, das aus der in eine ausgehärtete Matrix eingelagerten Armierung besteht, wobei die Armierung aus übereinanderliegenden Fadengelegen besteht, nach dem:
(a) mindestens einige der Gelege hergestellt werden, indem geradlinige Fadenabschnitte eines Endlosfadens auf einer Unterlage abgelegt werden, jeder Fadenabschnitt zwischen zwei Lagefixierungspunkten der Enden des Abschnitts gespannt wird, das Gelege so aus Fadenabschnitten gebildet wird, die mindestens annähernd parallel zueinander verlaufen, und die Fadenabschnitte des Geleges nach einer Richtung verlaufen, die entweder parallel oder quer zur Richtung der Fadenabschnitte eines anderen Geleges der Armierung verläuft, und
(b) sämtliche übereinanderliegenden Gelege insbesondere dadurch miteinander verbunden werden, daß ein Endlosfaden ohne Verschlingung durch die Gelege genäht wird,
dadurch gekennzeichnet, daß vor der Stufe (a) das mathematische Modell der herzustellenden Armierung erzeugt und gespeichert wird und für jedes herzustellende Gelege der Armierung mit Hilfe der gespeicherten Daten des mathematischen Modells der Armierung die Kontur des Geleges sowie dessen Lage gegenüber dem vorangegangenen bereits hergestellten Gelege bestimmt und anschließend der Prozeß von Stufe (a) gesteuert wird.

2. Verfahren nach Anspruch 1,
dadurch gekennzeichnet, daß für jedes abzulegende Fadengelege der Schnittpunkt der Hüllfläche der Armierung mit einer Schnittebene in der dem Gelege entsprechenden Höhe erzeugt wird, um so eine geschlossene Kurve zu erhalten, dann die Schnittpunkte dieser Kurve mit einem Gitter bestimmt werden, dessen Rasterschritt dem der abzulegenden Fäden entspricht, dessen Ebenen senkrecht zu der von der geschlossenen Kurve gebildeten Ebene verlaufen und dessen Richtung gleich der Orientierung der Gelegefäden ist.

3. Verfahren nach Anspruch 1 oder Anspruch 2,
dadurch gekennzeichnet, daß in der Stufe (a):
- die geradlinigen Fadenabschnitte mit Hilfe einer Nadel abgelegt werden, der gegenüber der Endlosfaden, zu dem jeder Fadenabschnitt gehört, gleiten kann, wobei sich die Nadel gegenüber der Unterlage bei gleichzeitigem Spannen des geradlinigen Fadenabschnitts über derselben über eine Länge verschieben kann, die gleich der Länge des geradlinigen Fadenabschnitts ist; und
- die geradlinigen Fadenabschnitte befestigt werden, indem mindestens ein Ende jedes Fadenabschnitts mit Hilfe der Nadel ohne Verschlingung in die Unterlage genäht wird.

4. System zur Anwendung des Verfahrens nach einem der Ansprüche 1 bis 3, der Art, daß es ein Werkzeug (1) zum Ablegen und/oder Vernähen des Fadens (F) hat, das mit Führungsmitteln (3) des Werkzeugs verbunden ist, durch die dieses nach drei quer zueinander verlaufenden Richtungen X, Y, Z bewegt wird, dadurch gekennzeichnet, daß es Mittel zum Speichern und Verarbeiten von Daten (5) hat, mit denen das mathematische Modell der herzustellenden Armierung (A) hergestellt und gespeichert werden kann und durch die die Führungsmittel (3) des Werkzeugs (1) gesteuert werden.

5. System nach Anspruch 4,
dadurch gekennzeichnet, daß das Werkzeug (1) zum Ablegen und/oder Vernähen des Fadens (F) an einer drehbaren Halterung (20) angebracht ist, an deren unterem Ende eine Nadel (2) angeordnet ist.

6. System nach Anspruch 4 oder Anspruch 5,
dadurch gekennzeichnet, daß die Führungsmittel (3) ein Gestell (8) mit einem Fuß (9) und Ständer (10), an denen sich jeweils eine Schiene (12) zur Anbringung einer Querstange (13) befindet, an der ein Schlitten (16) angebracht ist, der nach einer ersten Richtung X verschoben werden kann, mit einem ersten Arm (17) versehen ist, der nach einer zweiten Richtung Y senkrecht zur Richtung X verläuft und an dem sich ein zweiter Arm (18) befindet, der quer zu der von der Stange (13) und dem ersten Arm (17) gebildeten Ebene nach einer dritten Richtung Z verschiebbar ist, und Mittel (M1, M2, M3) zum Antrieb des Schlittens (16) und des ersten (17) und zweiten (18) Arms haben.

7. Armierung für ein Verbundmaterialteil, das aus der in eine ausgehärtete Matrix eingelagerten Armierung besteht,
dadurch gekennzeichnet, daß diese entsprechend dem Verfahren nach einem der Ansprüche 1 bis 3 hergestellt ist.

8. Verbundmaterialteil,
dadurch gekennzeichnet, daß es aus der in ein ausgehärtetes Harz eingelagerten Armierung von Anspruch 7 besteht.

## Claims

1. A method for producing a reinforcement for a composite component formed by said reinforcement embedded in a cured matrix, said reinforcement comprising superposed plies of thread, according to which method:
(a) at least some of said plies are produced by laying down straight portions of thread, forming part of a continuous thread, on a support, pulling tight each portion of thread between two points for positionally fixing the ends of said portion, the ply thus consisting of portions of thread extending at least substantially in parallel fashion with respect to each other, and the portions of thread of said ply extending in a direction which is either parallel or crossed with respect to the direction of the portions of threads of any other ply in the reinforcement; and
(b) all the superposed plies are consolidated, especially by stitching, without knotting, a continuous thread passing through said plies,
characterized in that prior to step (a), the mathematical model of the reinforcement to be produced is created and stored in memory and, for each ply to be produced of the reinforcement the contour of said ply together with its position relative to the previous ply already produced is defined with the aid of the data of the mathematical model of the reinforcement which are stored in memory and then the process of step (a) is initiated.

2. The method as claimed in claim 1, characterized in that for each ply of thread to be laid down, the intersection of the envelope surface of the reinforcement with a sectioning plane situated at the height corresponding to said ply is generated, thus obtaining a closed curve, then the points of intersection of this curve with an array, with spacing equal to the spacing of the threads to be laid down, of planes orthogonal to the plane defined by said closed curve and having a direction corresponding to that chosen as orientation for the threads of said ply are defined.

3. The method as claimed in claim 1 or claim 2, characterized in that, in step (a):
- said straight portions of thread are laid down by means of a needle, with respect to which the continuous thread, of which each of said portions forms a part, can slide, said needle being capable of moving relative to said support, pulling tight the straight portion of thread above the latter, to an extent equal to the length of said straight portion of thread; and
- said straight portions of thread are fixed by stitching, without knotting, at least one of the ends of each of said portions of thread into said support using said needle.

4. A system for the implementation of the method as claimed in any one of claims 1 to 3, of the type including a tool (1) for laying down and/or stitching thread (F), linked to means (3) for steering said tool, which means are intended to displace the latter in three mutually transverse directions X, Y, Z,
characterized in that it comprises means (5) for the memory storage and processing of data, in which the mathematical model of the reinforcement (A) to be produced can be created and stored in memory, and which are capable of operating said means (3) for steering said tool (1).

5. The system as claimed in claim 4, characterized in that said tool (1) for laying down and/or stitching thread (F) is mounted on a rotary support (20) at the lower end of which a needle (2) is arranged.

6. The system as claimed in claim 4 or claim 5, characterized in that said steering means (3) comprise a stand (8) provided with a subframe (9) and with uprights (10) each having a slideway (12) for mounting a transverse bar (13) on which is mounted a carriage (16), which can move in a first, X, direction, equipped with a first arm (17) extending in a second, Y, direction orthogonal to the X direction and carrying a second arm (18) able to slide transversely with respect to the plane defined by said bar (13) and said first arm (17) in a third, Z, direction, and motor means (M1, M2, M3) for driving said carriage (16) and said first arm (17) and second arm (18).

7. A reinforcement for a composite component formed by said reinforcement embedded in a cured matrix, characterized in that it is produced in accordance with the method as claimed in any one of claims 1 to 3.

8. A composite component, characterized in that it is formed by the reinforcement of claim 7 embedded in a cured resin.
